# EUROPEAN PATENT SPECIFICATION

(11) **EP 2 833 508 B1**
(45) Date of publication and mention of the grant of the patent: **15.11.2017**
(21) Application number: 12872947.2
(22) Date of filing: 28.03.2012
(51) Int. Cl.: H02J 50/00, H05K 13/04

(54) **NON-CONTACT POWER SUPPLY APPARATUS**
KONTAKTLOSE STROMVERSORGUNGSVORRICHTUNG
APPAREIL D'ALIMENTATION ÉLECTRIQUE SANS CONTACT

(43) Date of publication of application: 04.02.2015
(73) Proprietor: Fuji Machine Mfg. Co., Ltd., Chiryu-shi Aichi 472-8686 (JP)
(72) Inventor: NOMURA, Takeshi, Chiryu-shi Aichi 472-8686 (JP); ISHIURA, Naomichi, Chiryu-shi Aichi 472-8686 (JP)
(74) Representative: Grünecker Patent- und Rechtsanwälte PartG mbB
(86) International application number: PCT/JP2012/058223
(87) International publication number: WO 2013/145179

(56) References cited:
- JP-A- 2002 078 103
- JP-A- 2011 155 808
- JP-A- 2011 155 808

## Description

### Technical Field

The present invention relates to a contactless electric power supply device that supplies power to a current consumer on a movable section without contact, in particular, it relates to a contactless electric power supply device with improved cooling characteristics for the movable section compared to previously.

### Background Art

For board manufacturing equipment for producing boards mounted with multiple components there are solder printing machines, component mounters, reflow machines, board inspection machines and so on, and there are many cases in which these are configured into board producing lines by linking them with a board conveyance device. Many of these board manufacturing equipment are equipped with a movable section which performs work after moving to a specified position above the board, and a linear motor device can be used as a means for moving the movable section. A linear motor device is typically comprised of a track member with multiple magnets with alternating N poles and S poles arranged along the moving direction, and a movable section which includes an armature with a core and coil. In order to supply electricity to an electric consumer on the movable section, a deformable cable for supplying electricity has been used. Also, in recent years, in order to reduce negative effects such as risks of disconnections from metal fatigue and the load weight capacity increasing due to power supply cables, contactless electric power supply devices have been proposed.

Items such as the following are used for a current consumer equipped on a movable section. For example, on a mounting head which is a movable section on a component mounter, items such as an air pump for generating the vacuum pressure for suction nozzles to pick up components, and motors for rotating and lowering/raising suction nozzles, and a control section for these are provided. And, on an inspection head which is a movable section on a board inspection machine, items such as a camera for taking images of the wiring pattern on the board and the mounting status of components and a transmitting section for that data, and a control section are provided. Furthermore, the armature for a linear motor device is also a type of current consumer. In order to dissipate heat generated by the electric consumer on the movable section and restrict the rise in the temperature, there are cases of items such as heat dissipation fins being established, and this type of cooling configuration technology for a contactless electric power supply device has been disclosed in patent literature 1 and patent literature 2.

The contactless electric power supply device disclosed in claim 2 of patent literature 1 comprises an electric power receiving coil of an electric power receiving section, an electric power supply coil section of an electric power supply section which performs electromagnetic coupling to the electric power receiving coil, and a storage section which covers the area around the electric power receiving section and is provided on the electric power supply section; wherein the storage section is made from material with high thermal conductivity and is provided with a heat dissipation section on the outer surface. It is disclosed that, by this, it is possible to make it so people cannot touch the electric power supply coil section, and the electric power supply coil section temperature can be reduced by dissipating heat from the storage section.

In addition, the contactless electric power supply device of the flat surface display as disclosed in patent literature 2 supplies electric power using the electromagnetic induction effect by facing the electric power supply device with the electric power receiving device on the flat surface display side, and heat absorbing material is provided on the electric power supply device so that when electric power is supplied, the heat absorbing material contacts the electric power receiving device and absorbs heat. It is disclosed that, by this, good heat dissipation results can be achieved even when making items thin without including a large heat dissipation material inside the electric power receiving device.
Patent literature 3 discloses a non-contact power feeder pickup, a carrier, and a carrier system which can suppress coil temperature rise and magnetic flux leakage and prevent damages on the coil in occasional contacts with the feeder line. A heat radiator is provided on the outer surface of a pickup ring core which has an opening, and a magnetic flux shield plates are secured at the outside of the opening. A coil is wound on the pickup core center and molded together.

### Citation List

### Patent Literature

Patent Literature 1: Japanese Unexamined Patent Application Publication Number 2011-155808
Patent Literature 2: Japanese Unexamined Patent Application Publication Number 2006-280163
Patent Literature 3: Japanese Unexamined Patent Application Publication Number 2002-078103

### Summary of Invention

### Problem to be Solved by the Invention

Incidentally, contactless electric power supply devices are not limited to use just for board manufacturing equipment and there are many cases when they can be used as a means to provide electric power to a current consumer on a movable section. Here, if the heat dissipating area is made larger such as by making the movable section larger or providing heat dissipation fins in order to dissipate the heat generated from the current consumer, the weight of the movable section increases. Due to this, the problem that a large amount of moving power is required in order to move the movable section, and the problem that there are restrictions in the moving speed of the movable section arise.

For these problem points, for the technology from patent literature 1, there is technology for cooling the electric supply coil section of the fixed electric supply section, but this cannot apply to cooling the movable section.

In addition, even though the technology in patent literature 2 is electrically contactless, the cooling ability of the electric power receiving device side is improved by heat transfer with the electric power receiving device and electric power supply device contacting each other. With this technology, it is assumed that contact is maintained between the electric power receiving device and electric power supply device without them moving relative to each other while electric power is being supplied. Due to this, such as for board manufacturing equipment that have a linear motor device, this cannot apply to configurations for supplying electric power while maintaining clearance for the movable section when it is moving.

The present invention has been made in consideration of the problems in the background art, and an object thereof is to provide a contactless electric power supply device for which the movable section can be made more lightweight and compact than previously and which improves the cooling ability of the movable section using a contactless electric power supply element and a contactless electric power reception element to supply electric power to a current consumer on a movable section.

### Means for Solving the Problem

The present invention of a contactless electric power supply device from claim 1 which solves the above problems includes: a contactless electric power supply element provided on a fixed section, a high frequency power source circuit for supplying high frequency power to the contactless electric power supply element on the fixed section, a contactless electric power reception element for receiving high frequency electric power in a contactless manner which is facing and separated from the contactless electric power supply element and which is provided on the movable section movably mounted on the fixed section, an electric power reception circuit which supplies electric power to the current consumer on the movable section after converting the high-frequency power which the contactless electric power reception element received; wherein the contactless electric power reception element has a heat radiating layer or heat radiating surface which radiates the heat generated by and transferred from the current consumer with high emissivity in the surface facing and separated from the contactless electric power supply element, the contactless electric power supply element has a heat absorbing layer or heat absorbing surface which absorbs heat with a high absorption rate in the surface facing and separated from the contactless electric power reception element, such that the some of the heat generated by the current consumer is transferred from the contactless electric power reception element to the contactless electric power supply element and then diffused at the fixed section side.

For the invention from claim 2, with respect to claim 1, the heat radiating layer or the heat radiating surface has sheet material or paint including functional material converting the heat into far-infrared radiation and emitting it, or a high heat emissivity black colored coated surface, plated surface, or machine processed surface.

For the invention from claim 3, with respect to claim 1 or claim 2, the heat absorbing layer or the heat absorbing surface has the same configuration as that for the heat radiating layer or the heat radiating surface.

For the invention from claim 4, with respect to any of the claims from 1 to 3, the contactless electric power supply element and the contactless electric power reception element area are each electrode plates.

For the invention from claim 5, with respect to any of the claims from 1 to 4, at least one of the heat radiating layer or the heat absorbing layer has an insulation layer that serves the function of reinforcing the electrical insulation between the contactless electric power reception element and the contactless electric power supply element.

For the invention from claim 6, with respect to any of the claims from 1 to 5, also provided is a heat transfer member for accelerating the heat transfer to the contactless electric power reception element from the current consumer.

For the invention from claim 7, with respect to any of the claims from 1 to 6, the movable section is driven by a linear motor device while maintaining separation between the contactless electric power supply element and the contactless electric power reception element.

The present invention from claim 8, with respect to claim 7, is provided in a component mounter for mounting components on a circuit board and the movable section has a mounting head for performing the component mounting actions. Summary of Invention

In the present invention of a contactless electric power supply device from claim 1, the contactless electric power reception element has a heat radiating layer or heat radiating surface which emits heat with high emissivity, the contactless electric power supply element has a heat absorbing layer or heat absorbing surface for absorbing heat with a high absorption rate, and some of the heat generated by the current consumer is transferred from the contactless electric power reception element to the contactless electric power supply element by radiation and then diffused at the fixed section side. It follows that, the diffused heat volume from the movable section is reduced which improves the cooling ability, and the heat radiating area of the movable section can be made smaller than previously and can be made more lightweight and compact.

For the invention from claim 2, the surface for the contactless electric power reception element of the movable section side has a high heat emissivity configuration. It follows that, it is possible to increase the ratio of the amount of total heat generated at the movable section transferred to the fixed section, and it is clear that this results in the movable section becoming more lightweight and compact.

For the invention from claim 3, the heat absorbing layer or heat absorbing surface of the contactless electric power supply element on the fixed section side has the same configuration as that for the heat radiating layer or heat radiating surface for the contactless electric power reception element on the movable section side. Typically, a high heat emissivity surface also has a high heat absorption rate. It follows that, by using the same configuration at the fixed section side and movable section side, both the heat emissivity and heat absorption rate are improved, and the heat transfer ratio from the movable section to the fixed section can be greatly increased, which results in making the movable section even more lightweight and compact. In addition, by being able to use the same method for manufacturing the contactless electric power supply element of the fixed section side and the contactless electric power reception element of the movable section side, the manufacturing cost can be reduced.

For the invention from claim 4, the contactless electric power supply element and contactless electric power reception element are each electrode plates. For the electrostatic coupling types of contactless electric power supply device, typically the electrode area of facing and separated electrode plates is made large to maintain the electric power supply. It follows that, compared to other methods such as electromagnetic coupling types of contactless electric power supply device, it is easy to maintain the opposing surface areas contributing to transferring heat from the movable section to the fixed section. In addition, the ratio of the heat volume transferred from the movable section to the fixed section is increased, and it is clear that this results in the movable section becoming more lightweight and compact.

For the invention from claim 5, at least one of the heat radiating layer and heat absorbing layer also serves as an insulating layer. By this, the electrical insulation between the contactless electric power reception element and contactless electric power supply element is reinforced and the insulation performance is increased.

For the invention from claim 6, also provided is a heat transfer member for accelerating the heat transfer to the contactless electric power reception element from the current consumer. From point of view of heat conduction, it is desirable to directly join the current consumer and the contactless electric power reception element without some other member being between them, but there are electrical insulation requirements, structural limitations, and so on. Due to this, by using, for example, a heat transfer sheet that has good adherence for the heat transfer member for accelerating the heat transfer to the contactless electric power reception element from the current consumer, the thermal conduction volume can be increased. By this, the ratio of the heat volume transferred from the movable section to the fixed section can be increased, and it is clear that this results in the movable section becoming more lightweight and compact.

For the invention from claim 7, the movable section is driven by the linear motor device while maintaining separation between the contactless electric power supply element and contactless electric power reception element. The present invention of a contactless electric power supply device can be used to supply power to a movable section driven by a linear motor device, and the movable section can be more lightweight and compact.

The present invention from claim 8 is provided in a component mounter for mounting components on a circuit board and the movable section has a mounting head for performing the component mounting actions. The present invention of a contactless electric power supply device can be provided in a component mounter and the movable section with the mounting head can be more lightweight and compact. By this, the moving power in order to drive the mounting head can be reduced compared to previously, and in addition the mounting head moving speed can be increased compared to previously, and the component mounting rate can be made higher.

### Brief Description of Drawings

[FIG. 1] This is a perspective view showing the overall configuration of a component mounter which can use the contactless electric power supply device of the present invention.
[FIG. 2] This is a diagram to illustrate conceptually the contactless electric power supply device of the embodiment.
[FIG. 3] This is a diagram to illustrate conceptually a conventional technology contactless electric power supply device.

### Description of Embodiments

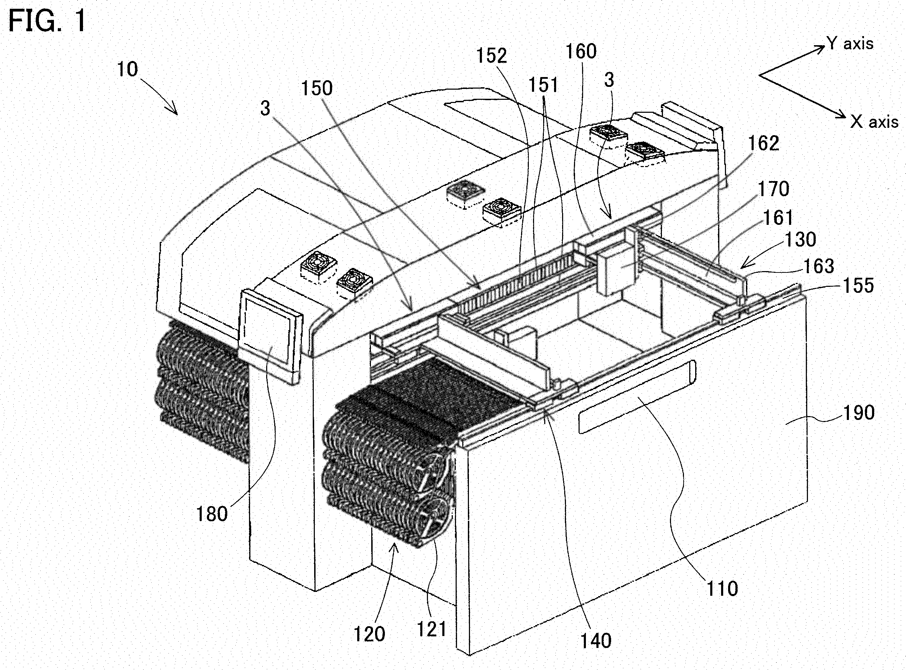

First, component mounter 10 which can use the contactless electric power supply device of the present invention is described with reference to FIG. 1. FIG. 1 is a perspective view showing the overall configuration of component mounter 10 which can use contactless electric power supply device 1 of the present invention. Component mounter 10 is a device for mounting many components onto a board, and has a configuration in which two sets of component mounting units with the same construction are arranged largely with bilateral symmetry. Here, a component mounting unit with the cover removed at the front right side of FIG. 1 is described as an example. In the figure, the width of component mounter 10 going from the left rear side to the front right side is the X-axis direction, and the length of component mounter 10 is the Y-axis direction.

Component mounter 10 is configured with board conveyance device 110, component supply device 120, two component transfer devices 130 and 140, and so on assembled to base 190. Board conveyance device 110 is transversely in the X-axis direction around the center of the lengthwise direction of component mounter 10. Board conveyance device 110 uses a conveyor which is omitted from the figure and conveys boards in the X-axis direction. Also, board conveyance device 110 uses a clamp device which is omitted from the figure and secures and holds boards at a predetermined mounting work position. Component supply device 120 is provided at the front section (the left front side of FIG. 1) in the lengthwise direction of component mounter 10. Component supply device 120 uses multiple cassette type feeders 121, and components are consecutively supplied to the two component transfer devices 130 and 140 from carrier tape set in each feeder 121.

The two component transfer devices 130 and 140 are what are known as XY-robot type devices, which can move in the X-axis direction and Y-axis direction. The two component transfer devices 130 and 140 are arranged facing each other at the front side and rear side of component mounter 10 in the lengthwise direction. To move each component transfer device 130 and 140 in the Y-axis direction, there is a linear motor device 150. Linear motor device 150 includes support rail 155 and track member 151 shared for the two component transfer devices 130 and 140 and movable section 3 for each of the two component transfer devices 130 and 140. Track member 151 is arranged parallel on both sides sandwiching movable section 3 and extends in the Y-axis direction which is the moving direction. On the internal facing surfaces of track member 151, multiple magnets 152 are arranged in a row in the Y-axis direction. Movable section 3 is movably mounted on track member 151.

Movable section 3 includes movable main body section 160, X-axis rail 161, mounting head 170, and the like. Movable main body section 160 extends in the Y-axis direction, and an armature that generates driving force facing magnets 152 for track member 151 is arranged on both side surfaces. X-axis rail 161 extends in the X-axis direction from the movable main body section 160. End 162 of the X-axis rail 161 is connected to the movable main body section 160, and the other end 163 is movably mounted on support rail 155, such that it moves in the Y-axis direction. Component mounting head 170 is mounted on X-axis rail 161 such that it moves in the X-axis direction. Suction nozzles which are omitted from the figure are provided on the lower side of component mounting head 170. Suction nozzles use negative pressure to pick up components from component supply device 120 and mount them on the printed circuit board at the mounting work position. The ball screw mechanism which is omitted from the figure mounted on X-axis rail 161 has an X-axis motor that provides the ball screw rotational movement, and drives mounting head 170 in the X-axis direction.

Component mounter 10 is also provided with display settings device 180 for exchanging information with operators, cameras for capturing images of boards and components which are omitted from the figure, and so on.

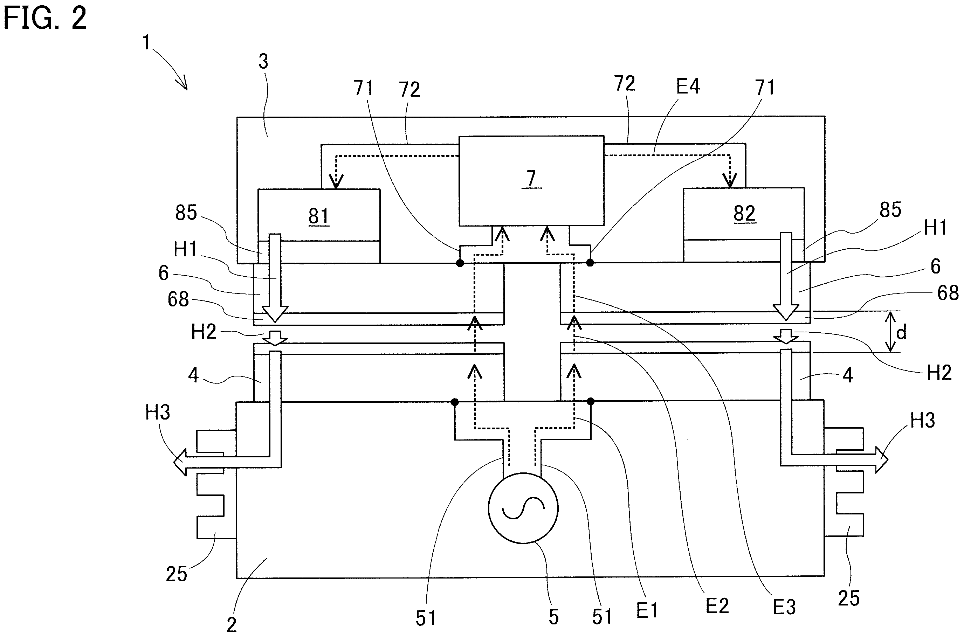

Next, details are given about contactless electric power supply device 1 of an embodiment of this invention. FIG. 2 is a diagram to illustrate conceptually contactless electric power supply device 1 of the embodiment. Contactless electric power supply device 1 is a device that provides contactless electric power by electrostatic coupling to movable section 3 of linear motor device 150 from fixed section 2 on base 190 of component mounter 10 mentioned above. Contactless electric power supply device 1 is comprised of contactless electric power supply element 4, high-frequency power source circuit 5, contactless electric power reception element 6, electric power reception circuit 7, and the like. In FIG. 2, the dashed arrows E1 to E4 indicate the electric power flow, and the white arrows H1 to H3 indicate the heat flow.

Two contactless electric power supply elements 4 are established on fixed section 2 and are electrode plates for supplying electric power and are formed from metal materials. High-frequency power source circuit 5 is established on fixed section 2 and outputs high-frequency electric power. From the two output terminals of high-frequency power source circuit 5, one is connected to the first contactless electric power supply element 4 and the other is connected to the second contactless electric power supply element 4 by power wires 51. The output frequency for the high-frequency power source circuit 5 may be exemplified from the 100 kHz to MHz band and the output voltage waveform may be exemplified by a sinusoidal wave, a rectangular wave, and the like.

Two contactless electric power reception elements 6 are established on movable section 3 and are electrode plates for receiving electric power and are formed from metal materials. Contactless electric power reception element 6 and contactless electric power supply element 4 face each other and are separated by a small distance d and electrically constitute a parallel-plate capacitor. Even though movable section 3 is moved by linear motor device 150, the separation distance d is mostly maintained uniformly. In order to obtain the prescribed supplied electric power, contactless electric power supply element 4 and contactless electric power reception element 6 maintain large opposing surface areas.

Electric power reception circuit 7 is established on movable section 3 and converts the high frequency electric power inputted from contactless electric power reception element 6 and outputs it. From the input terminals of electric power reception circuit 7, one is connected to the first contactless electric power reception element 6 and the other is connected to the second contactless electric power reception element 6 by power wires 71. In electric power reception circuit 7, for example, an inverter may be used to change and output the inputted high frequency electric power at least as direct current electric power and commercial alternating current electric power. When there is a difference in the voltage amount and frequency for electric consumers 81 and 82 mentioned below, a multiple output electric power reception circuit 7 can be used.

As shown in FIG. 2, a closed circuit which performs contactless electric power supply includes high-frequency power source circuit 5, two contactless electric power supply elements 4, two contactless electric power reception elements 6, and electric power reception circuit 7.

On the other hand, current consumers 81 and 82 which are the power supply target of the contactless electric power supply are provided on movable section 3. The current consumers may be exemplified by X-axis motor 81 which drives the ball screw for moving the mounting head 170 mentioned above in the X-direction, the air pump for generating negative pressure, and control circuit board 82 for controlling these. Furthermore, the armature for a linear motor device 150 is also a current consumer. These current consumers 81 and 82 are connected to the output side of electric power reception circuit 7 by power wires 72 so that electric power is supplied. Further, it is acceptable for current consumers 81 and 82 to be either a direct current consumer or an alternating current consumer and the amount of voltage is also not limited, but it is necessary for the electric power reception circuit 7 to have an output function that supports current consumers 81 and 82.

The above is the electrical configuration of the embodiment of contactless electric power supply device 1. The high frequency electric power output from high-frequency power source circuit 5 inputs electric power into the two contactless electric power supply elements 4 via power wires 51 (dashed arrow E1 in FIG. 2), and by using electrostatic coupling of the parallel-plate capacitor, supplies contactless electric power (dashed arrow E2) to the two contactless electric power reception elements 6. Furthermore, the high frequency electric power received by the two contactless electric power reception elements 6 is input (dashed arrow E3) to electric power reception circuit 7 via power wires 71, and the electric power (dashed arrow E4) is converted in electric power reception circuit 7 and supplied to current consumers 81 and 82. From this, current consumers 81 and 82 operate and heat loss occurs.

The following describes the cooling configuration (thermal configuration) for the embodiment of contactless electric power supply device 1. Heat transfer member 85 is provided between current consumers 81 and 82 and the contactless electric power reception elements 6. Heat transfer member 85 accelerates the heat transfer to contactless electric power reception element 6 from current consumers 81 and 82 and is material for maintaining electrical insulation between both. Heat transfer member 85 can use, for example, a resin heat transfer sheet with a comparatively large thermal conductivity rate. As well as heat transfer member 85 closely contacting both current consumers 81 and 82 and contactless electric power reception elements 6 so that heat conducting is performed well, it is desirable for heat transfer member 85 to be thin within the acceptable limitation range for electrical insulation and mechanical strength and so on.

Contactless electric power reception element 6 has heat radiating layer 68 in the surface which is facing and separated from the contactless electric power supply element 4. Heat radiating layer 68 is an item for radiating the heat generated by and transferred from the current consumers 81 and 82 with high emissivity. Heat radiating layer 68, for example, uses sheet material or paint including functional material for converting the heat into far-infrared radiation and emitting it. For the functional material which converts the heat into far-infrared radiation, there are multiple types already available in the market, but items such as the chemical composition of these are almost never disclosed. This is not limited to this and it is acceptable to coat the surface of the contactless electric power reception element 6 with a black coating that has a high heat emissivity as an alternative to heat radiating layer 68. Furthermore, it is also acceptable to use items such as a plated surface with high heat emissivity, or machine processed surface provided with very small bumps and indentations for high heat emissivity.

In addition, it is possible for heat radiating layer 68 to also serve as an insulation layer by forming it using insulating materials. By this, heat radiating layer 68 can reinforce the electrical insulation between the contactless electric power reception element 6 and contactless electric power supply element 4 and the insulation performance can be increased.

On the other side, contactless electric power supply element 4 on fixed section 2 has heat absorbing layer 48 which absorbs the heat with a high absorption rate in the surface which is facing and separated from contactless electric power reception element 6. It is acceptable for heat absorbing layer 48 to have the same configuration as that of heat radiating layer 68 for contactless electric power reception element 6, or for it to have a different configuration. Furthermore, in the same manner as for heat radiating layer 68, it is possible to use items such as a black coated surface, plated surface, or machine processed surface as an alternative for heat absorbing layer 48. In addition, it is possible for heat absorbing layer 48 to be formed using insulating materials to also serve as an insulation layer in the same manner.

Heat dissipation fin 25 is provided near contactless electric power supply element 4 of fixed section 2. Heat dissipation fin 25 is one means for controlling the raise in the temperature of fixed section 2 and there are many various applications and modifications possible. For example, when heat dissipation fin 25 provides insufficient radiation, it is acceptable to add a cooling fan. And, for example, when fixed section 2 is large and it is possible to obtain sufficient radiation just from the surface area thereof, it is acceptable to omit heat dissipation fin 25.

Next is described the cooling effect for the contactless electric power supply device 1 of an embodiment configured like that above. Part of the total heat generated by current consumers 81 and 82 is directly radiated from the surface of movable section 3, while the remaining amount of heat is transferred to contactless electric power reception element 6 via heat transfer member 85 (white arrow H1 in FIG. 2). And the heat of contactless electric power reception element 6 is radiated into the air from the effect of heat radiating layer 68, and much of the radiated heat is transferred to contactless electric power supply element 4 from the effect of heat absorbing layer 48. Further, the heat of contactless electric power supply element 4 is transferred from fixed section 2 to heat dissipation fin 25 and radiated.

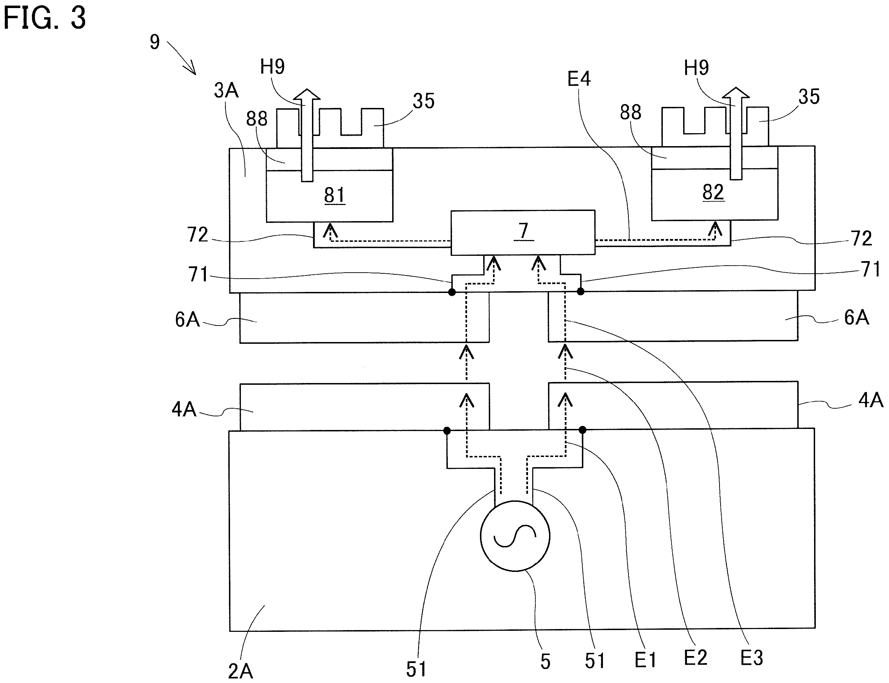

The following is a description of the effectiveness of embodiment of contactless electric power supply device 1 compared to conventional technology. FIG. 3 is a diagram to illustrate conceptually a conventional technology contactless electric power supply device 9. Conventional technology contactless electric power supply device 9, which is used in devices with the same applications as the embodiment, is comprised of contactless electric power supply element 4A, high-frequency power source circuit 5, contactless electric power reception element 6A, electric power reception circuit 7, and the like. Because the electrical configuration of conventional technology contactless electric power supply device 9 is almost the same as the embodiment, the same dashed arrows E1 to E4 as that shown in FIG. 2 indicate the flow of electric power and a detailed description is omitted.

On the other hand, the cooling configuration (thermal configuration) of conventional technology contactless electric power supply device 9 is different from the embodiment, there is no heat transfer route from contactless electric power reception element 6A to contactless electric power supply element 4A, and mainly all of the heat is radiated from the movable section 3A side. As shown in FIG. 3, there is no heat radiating layer 68 for contactless electric power reception element 6A, and there is no heat absorbing layer 48 for contactless electric power supply element 4A, and no heat dissipation fin 25 provided on fixed section 2A. Instead, heat dissipation fin 35 is provided on movable section 3A and heat transfer member 88 is provided between heat dissipation fin 35 and current consumers 81 and 82. It follows that, much of the heat generated by current consumers 81 and 82 of movable section 3A is transferred to heat dissipation fin 38 via heat transfer members 88 (white arrows H9 in FIG) and radiated by the movable section 3A side.

As can be seen by comparing FIG. 2 and FIG. 3, for the embodiment, because part of the heat generated by current consumers 81 and 82 is transferred to fixed section 2 and radiated, it is possible to eliminate heat dissipation fin 35 on movable section 3 and by that amount, movable section 3 can be made more compact and lightweight than conventional technology. By this, the moving power in order to drive mounting head 170 for component mounter 10 can be reduced compared to previously, and in addition the mounting head 170 moving speed can be increased compared to previously, and the component mounting rate can be made higher.

In addition, contactless electric power supply element 4 and contactless electric power reception element 6 used for electrostatic coupling are each electrode plates and maintain large opposing surface areas. Further, contactless electric power reception element 6 on the movable section 3 side has heat radiating layer 68, and contactless electric power supply element 4 on the fixed section 2 side has heat absorbing layer 48. Additionally, heat transfer member 85 is provided between current consumers 81 and 82 and contactless electric power reception elements 6 on the movable section 3 side. These overall effects mean that it is possible to increase the ratio of the amount of total heat generated at movable section 3 transferred to fixed section 2, and movable section 3 becomes even more lightweight and compact.

In addition, in a situation in which heat radiating layer 68 and heat absorbing layer 48 have the same configuration, by being able to use the same method for manufacturing contactless electric power supply element 4 and contactless electric power reception element 6, the manufacturing cost can be reduced. Additionally, in a situation in which at least one of the heat radiating layer 68 and heat absorbing layer 48 simultaneously also has an insulating layer, the electrical insulation between contactless electric power reception element 6 and contactless electric power supply element 4 is reinforced and the insulation performance is increased.

Further, it is desirable to apply the present invention to an electrostatic coupling type of contactless electric power supply device 1, but the present invention can also be applied to other kinds of contactless electric power supply devices such as electromagnetic induction and magnetic field resonance. Various other applications and modifications are possible for the present invention as defined in the claims.

### Industrial Applicability

The present invention of a contactless electric power supply device can be employed in a component mounter 10, and can be employed in other board manufacturing equipment. The present invention of a contactless electric power supply device can also be used as a means for moving power for items other than linear motor device 150, for example it can be used in various devices for moving power of movable sections in ball screw driven devices.

### Symbol descriptions

1: Contactless electric power supply device
2, 2A: Fixed section
25: Heat dissipation fin
3, 3A: Movable section
35: Heat dissipation fin
4, 4A: Contactless electric power supply element
48: Heat absorbing layer
5: High-frequency power source circuit
6, 6A: Contactless electric power reception element
68: Heat radiating layer
7: Electric power reception circuit
81: X-axis motor (current consumer)
82: Control circuit board (current consumer)
85: Heat transfer member
88: Heat transfer member
9: Conventional technology contactless electric power supply device
10: Component mounter
110: Board conveyance device
120: Component supply device
130, 140: Component transfer device
150: Linear motor device
160: Movable main body section
161: X-axis rail
170: Mounting head
180: Display settings device
190: Base

## Claims

1. A contactless electric power supply device (1) for board manufacturing equipment, the contactless electric power supply device (1) comprising a contactless electric power supply element (4) provided on a fixed section (2), a high frequency power source circuit (5) for supplying high frequency power to the contactless electric power supply element (4) on the fixed section (2), a contactless electric power reception element (6) for receiving high frequency electric power in a contactless manner which is facing and separated from the contactless electric power supply element (4) and which is provided on a movable section (3) movably mounted on the fixed section (2), an electric power reception circuit (7) which supplies electric power to a current consumer (81, 82) on the movable section (3) after converting the high-frequency power which the contactless electric power reception element (6) received; wherein the contactless electric power reception element (6) has a heat radiating layer (68) or heat radiating surface which radiates the heat generated by and transferred from the current consumer (81, 82) with high emissivity in the surface facing and separated from the contactless electric power supply element (4), the contactless electric power supply element (4) has a heat absorbing layer (48) or heat absorbing surface which absorbs heat with a high absorption rate in the surface facing and separated from the contactless electric power reception element (6), such that some of the heat generated by the current consumer (81, 82) is transferred from the contactless electric power reception element (6) to the contactless electric power supply element (4) and then diffused at the fixed section (2) side.

2. The contactless electric power supply device (1) according to claim 1 in which the heat radiating layer (68) or the heat radiating surface has sheet material or paint including functional material converting the heat into far-infrared radiation and emitting it, or a high heat emissivity black colored coated surface, plated surface, or machine processed surface.

3. The contactless electric power supply device (1) according to claim 1 or claim 2 in which the heat absorbing layer (48) or the heat absorbing surface has the same configuration as that for the heat radiating layer (68) or the heat radiating surface.

4. The contactless electric power supply device (1) according to any one of claims 1 to 3 in which the contactless electric power supply element (4) and the contactless electric power reception element (6) area are each electrode plates.

5. The contactless electric power supply device (1) according to any one of claims 1 to 4 in which at least one of the heat radiating layer (68) or the heat absorbing layer (48) has an insulation layer that serves the function of reinforcing the electrical insulation between the contactless electric power reception element (6) and the contactless electric power supply element (4).

6. The contactless electric power supply device (1) according to any one of claims 1 to 5 in which also provided is a heat transfer member (85) for accelerating the heat transfer to the contactless electric power reception element (6) from the current consumer (81, 82).

7. The contactless electric power supply device (1) according to any one of claims 1 to 6 in which the movable section (3) is driven along track member by a linear motor device (150) while maintaining separation between the contactless electric power supply electrode plate and the contactless electric power reception electrode plate.

8. The contactless electric power supply device (1) according to claim 7 in which the movable section (3) is provided in a component mounter (10) for mounting components on a circuit board and which is further provided with a mounting head (170) for performing component mounting actions.

## Patentansprüche

1. Kontaktlose Elektroenergie-Zuführvorrichtung (1) für Platten-Herstellungsanlagen, wobei die kontaktlose Elektroenergie-Zuführvorrichtung (1) ein kontaktloses Elektroenergie-Zuführelement (4), das sich an einem stationären Abschnitt (2) befindet, eine Hochfrequenzenergiequellen-Schaltung (5) zum Zuführen von Hochfrequenzenergie zu dem kontaktlosen Elektroenergie-Zuführelement (4) an dem stationären Abschnitt (2), ein kontaktloses Elektroenergie-Empfangselement (6) zum kontaktlosen Empfangen von Hochfrequenz-Elektroenergie, das dem kontaktlosen Elektroenergie-Zuführelement (4) zugewandt und von ihm entfernt ist und sich an einem beweglichen Abschnitt (3) befindet, der beweglich an dem stationären Abschnitt (2) angebracht ist, eine Elektroenergie-Empfangsschaltung (7) umfasst, die einem Stromverbraucher (81, 82) an dem beweglichen Abschnitt (3) nach Umwandeln der durch das kontaktlose Elektroenergie-Empfangselement (6) empfangenen Hochfrequenzenergie Elektroenergie zuführt, wobei das kontaktlose Elektroenergie-Empfangselement (6) eine Wärme abstrahlende Schicht (68) oder eine Wärme abstrahlende Oberfläche, die durch den Stromverbraucher (81, 82) erzeugte und von ihm übertragene Wärme mit hohem Emissionsvermögen an der Oberfläche abstrahlt, die dem kontaktlosen Elektroenergie-Zuführelement (4) zugewandt und von ihm entfernt ist, das kontaktlose Elektroenergie-Zuführelement (4) eine Wärme absorbierende Schicht (48) oder eine Wärme absorbierende Oberfläche aufweist, die Wärme mit einer hohen Absorptionsrate an der Oberfläche absorbiert, die dem kontaktlosen Elektroenergie-Empfangselement (6) zugewandt und von ihm entfernt ist, so dass ein Teil der durch den Stromverbraucher (81, 82) erzeugten Wärme von dem kontaktlosen Elektroenergie-Empfangselement (6) zu dem kontaktlosen Elektroenergie-Zuführelement (4) übertragen und dann an der Seite des stationären Abschnitts (2) diffundiert wird.

2. Kontaktlose Elektroenergie-Zuführvorrichtung (1) nach Anspruch 1, wobei die Wärme abstrahlende Schicht (68) oder die Wärme abstrahlende Oberfläche Folienmaterial oder Beschichtung, das/die funktionales Material enthält, das die Wärme in ferne Infrarotstrahlung umwandelt und sie emittiert, oder eine mit schwarzer Farbe beschichtete Oberfläche, eine plattierte Oberfläche oder eine maschinell bearbeitete Oberfläche mit hohem Wärmeemissionsvermögen aufweist.

3. Kontaktlose Elektroenergie-Zuführvorrichtung (1) nach Anspruch 1 oder Anspruch 2, wobei die Wärme absorbierende Schicht (48) oder die Wärme absorbierende Oberfläche den gleichen Aufbau hat wie die Wärme abstrahlende Schicht (68) oder die Wärme abstrahlende Oberfläche.

4. Kontaktlose Elektroenergie-Zuführvorrichtung (1) nach einem der Ansprüche 1 bis 3, wobei das kontaktlose Elektroenergie-Zuführelement (4) und das kontaktlose Elektroenergie-Empfangselement (6) jeweils Elektrodenplatten sind.

5. Kontaktlose Elektroenergie-Zuführvorrichtung (1) nach einem der Ansprüche 1 bis 4, wobei die Wärme abstrahlende Schicht (68) oder/und die Wärme absorbierende Schicht (48) eine Isolierschicht aufweist/aufweisen, die dazu dient, die elektrische Isolierung zwischen dem kontaktlosen Elektroenergie-Empfangselement (6) und dem kontaktlosen Elektroenergie-Zuführelement (4) zu verstärken.

6. Kontaktlose Elektroenergie-Zuführvorrichtung (1) nach einem der Ansprüche 1 bis 5, wobei des Weiteren ein Wärmeübertragungselement (85) vorhanden ist, mit dem die Wärmeübertragung zu dem kontaktlosen Elektroenergie-Empfangselement (6) von dem Stromverbraucher (81, 82) beschleunigt wird.

7. Kontaktlose Elektroenergie-Zuführvorrichtung (1) nach einem der Ansprüche 1 bis 6, wobei der bewegliche Abschnitt (3) durch eine Linearmotor-Vorrichtung (150) an einem Bahnelement angetrieben wird und dabei Entfernung zwischen der kontaktlosen Elektroenergie-Zuführ-Elektrodenplatte und der kontaktlosen Elektroenergie-Empfangs-Elektrodenplatte aufrechterhalten wird.

8. Kontaktlose Elektroenergie-Zuführvorrichtung (1) nach Anspruch 7, wobei sich der bewegliche Abschnitt (3) in einer Bauteil-Montagevorrichtung (10) zum Montieren von Bauteilen an einer Leiterplatte befindet und sie des Weiteren mit einem Montagekopf (170) zum Durchführen von Bauteil-Montagevorgängen versehen ist.

## Revendications

1. Dispositif d'alimentation électrique sans contact (1) destiné à un équipement de fabrication de cartes, le dispositif d'alimentation électrique sans contact (1) comprenant un élément d'alimentation électrique sans contact (4) disposé sur une section fixe (2), un circuit de source d'énergie haute fréquence (5) destiné à délivrer de l'énergie haute fréquence à l'élément d'alimentation électrique sans contact (4) sur la section fixe (2), un élément de réception d'énergie électrique sans contact (6) destiné à recevoir de l'énergie électrique haute fréquence sans contact, lequel fait face à l'élément d'alimentation électrique sans contact (4) et est séparé de celui-ci, et lequel est disposé sur une section mobile (3) montée pour pouvoir se déplacer sur la section fixe (2), un circuit de réception d'énergie électrique (7) qui fournit l'énergie électrique à un consommateur de courant (81, 82) sur la section mobile (3) après avoir converti l'énergie haute fréquence qu'a reçu l'élément de réception d'énergie électrique sans contact (6) ; l'élément de réception d'énergie électrique sans contact (6) comportant une couche rayonnant de la chaleur (68) ou une surface rayonnant de la chaleur qui rayonne la chaleur générée par le consommateur de courant (81, 82) et transférée depuis celui-ci avec une émissivité élevée dans la surface faisant face à l'élément d'alimentation électrique sans contact (4) et séparée de celui-ci, l'élément d'alimentation électrique sans contact (4) comportant une couche d'absorption de la chaleur (48) ou une surface d'absorption de la chaleur qui absorbe la chaleur avec un haut débit d'absorption de chaleur dans la surface faisant face à l'élément de réception d'énergie électrique sans contact (6) et séparée de celui-ci, de sorte qu'une partie de la chaleur générée par le consommateur de courant (81, 82) est transférée depuis l'élément de réception d'énergie électrique sans contact (6) jusqu'à l'élément d'alimentation électrique sans contact (4) puis est diffusée au niveau du côté de la section fixe (2).

2. Dispositif d'alimentation électrique sans contact (1) selon la revendication 1, dans lequel la couche rayonnant de la chaleur (68) ou la surface rayonnant de la chaleur comporte un matériau en tôle ou une peinture incluant un matériau fonctionnel convertissant la chaleur en rayonnement infrarouge et émettant celle-ci, ou bien une surface enduite colorée en noir d'émissivité élevée, une surface plaquée, une surface traitée par machine.

3. Dispositif d'alimentation électrique sans contact (1) selon la revendication 1 ou la revendication 2, dans lequel la couche d'absorption de chaleur (48) ou la surface d'absorption de chaleur présente la même configuration que celle décrite pour la couche rayonnant de la chaleur (68) ou la surface rayonnant de la chaleur.

4. Dispositif d'alimentation électrique sans contact (1) selon l'une quelconque des revendications 1 à 3, dans lequel l'élément d'alimentation électrique sans contact (4) et l'élément de réception d'énergie électrique sans contact (6) sont chacun des plaques d'électrodes.

5. Dispositif d'alimentation électrique sans contact (1) selon l'une quelconque des revendications 1 à 4, dans lequel au moins l'une de la couche rayonnant de la chaleur (68) ou de la couche d'absorption de chaleur (48) comporte une couche d'isolement qui assiste la fonction de renforcement de l'isolement électrique entre l'élément de réception d'énergie électrique sans contact (6) et l'élément d'alimentation électrique sans contact (4).

6. Dispositif d'alimentation électrique sans contact (1) selon l'une quelconque des revendications 1 à 5, dans lequel est également prévu un élément de transfert de la chaleur (85) destiné à accélérer le transfert de chaleur provenant du consommateur de courant (81, 82) vers l'élément de réception d'énergie électrique sans contact (6).

7. Dispositif d'alimentation électrique sans contact (1) selon l'une quelconque des revendications 1 à 6, dans lequel la section mobile (3) est entraînée le long d'un élément de piste grâce à un moteur linéaire (150) tout en conservant la séparation entre la plaque d'électrode d'alimentation électrique sans contact et la plaque d'électrode de réception d'énergie électrique sans contact.

8. Dispositif d'alimentation électrique sans contact (1) selon la revendication 7, dans lequel la section mobile (3) est prévue dans un dispositif de montage de composants (10) destiné à monter des composants de carte à circuit imprimé, lequel est en outre doté d'une tête de montage (170) destinée à effectuer des actions de montage de composants.
